Europäisches Patentamt

European Patent Office

Office européen des brevets

(11) Publication number: 0 046 298
A1

# EUROPEAN PATENT APPLICATION

(21) Application number: 81106393.2

(22) Date of filing: 17.08.81

(51) Int. Cl.³: **G 01 R 33/032**, G 01 R 15/07, G 02 F 1/09, H 01 F 1/34, C 04 B 35/40

(30) Priority: 18.08.80 JP 112742/80

(43) Date of publication of application: 24.02.82 Bulletin 82/8

(84) Designated Contracting States: **DE FR GB NL**

(71) Applicant: **Hitachi, Ltd., 5-1, Marunouchi 1-chome, Chiyoda-ku Tokyo 100 (JP)**

(72) Inventor: **Matsumura, Hiroyoshi, 264-61, Ohaza Kubo Hidaka-cho, Iruma-gun Saitama-ken (JP)**
Inventor: **Katsuyama, Toshio, 1-47-1, Akatsuki-cho, Hachioji-shi Tokyo (JP)**
Inventor: **Suganuma, Tsuneo, 5-17-5, Nakaarai, Tokorozawa-shi Saitama-ken (JP)**
Inventor: **Ando, Keikichi, 4-2-7, Hachiman-cho, Musashino-shi Tokyo (JP)**
Inventor: **Ohta, Norio, 15-105, Sayama-green-hights Sasai, Sayama-shi Saitama-ken (JP)**

(74) Representative: **Strehl, Peter K.L. Schiff, Dr. A.v. Füner et al, Dipl. Ing. P. Strehl Dr. U. Schübel-Hopf Dipl. Ing. D.Ebbinghaus Dr. Ing. D. Finck Patentanwälte Mariahilfplatz 2&3, D-8000 München 90 (DE)**

(54) Apparatus for measuring a magnetic field.

(57) A magnetic field measuring apparatus is effective for measuring magnetic fields in places, where electrical means cannot be adopted for the measurement. The detecting portion (C) ist constructed of a small magnetic material having the Faraday rotation and is disposed at the end part or intermediate part of an optical fiber (1). Light is guided to the detecting portion (C) by the optical fiber (1). Transmitted or reflected light subjected to the Faraday rotation proportional to the intensity of the magnetic field in the detecting portion (C) is guided to a measuring portion (A) by the optical fiber (1).

APPARATUS FOR MEASURING A MAGNETIC FIELD

The invention relates to an apparatus for measuring a magnetic field.

For the prevention of any fault of a system, such as transformer and insulator, which produces a high voltage and whose internal structure cannot be seen with the eyes, and especially for the preventive maintenance of a high-voltage equipment for which an insulation is eagerly requested, it is effective to monitor the variations of the electric or magnetic field of the system or equipment during normal usage.

For the measurement of the magnetic field of the high-voltage equipment, there has heretofore been used an apparatus which employs a detecting coil of metal wire, which detects a magnetic field in terms of a current or voltage. Thereby the usage of the metal coil is possible in cases where the measuring space has a rather large space or where a satisfactory insulation can be maintained even when the coil  is inserted. However, such measurements are dangerous and difficult to perform in places of very restricted space or in cases where the insulation is problematic on account of a very high voltage. This is particularly true for substations or transformers, which handle 100 K V or even 500 K V.

It is therefore object of this invention to provide an apparatus which can safely and readily measure magnetic fields within a very small space, allowing the performance of precise measurement of low magnetic fields below several hundred gausses.

In accordance with the invention this object can be obtained by that there are provided a light source, a magnetic field detecting portion  including a medium having the Faraday rotation, a measuring portion, measuring light from the detecting portion, and an optical fiber connecting the light source, the detecting portion and the measuring portion.

In the framework of the invention, a magnetic garnet film is employed as the medium having the Faraday rotation. Thereby the magnetic garnet is represented by the formula $R_3(Fe_{5-x}M_x)_5O_{12}$ where R and M denotes at least one element selected from the corresponding groups R = {Y, Ce, Pr, Nd, Bi, Pb, La, Sm, Eu, Gd, Tm, Yb, Lu, Ca} and M = { Ga, Ge, Al, Si, Sc, In, Cr}.

In order to facilitate the reproductibility of the measurements, the magnetic garnet film is formed by liquid phase epitaxy or chemical vapor deposition (CVD process) on at least one surface of a paramagnetic substrate of, e.g. gadolinium gallium garnet $Gd_3Ga_5O_{12}$, neodymium gallium garnet $Nd_3Ga_5O_{12}$ or samarium gallium garnet $Sm_3Ga_5O_{12}$, which for the sake of brevity shall be called GGG, NdGG or SmGG respectively. Thereby the direction of magnetization becomes perpendicular to the surface, and is coupled with an optical fiber in such s way that the propagating direction of light coincides with the magnetization direction. The optical fiber to be used can be either a single-mode or multi-mode fiber, and it may be constructed either as a single fiber or a fiber bundle.

According to this invention, the magnetic field detecting portion is disposed either at the end or at an intermediate part of the optical fiber and has a very small volume, so that it can be readily inserted into a very small space. The detecting portion and the measuring portion are coupled by the optical fiber, so that the measurements are not affected by external voltages and currents. Thus, the invention provides an effective mean for magnetic field measurements of high-voltage equipment, which up to now were difficult to perform. In addition, the sensor employed is small in size and has a high Faraday rotation efficiency. Further, through the use of a garnet film whose magnetization direction is perpendicular to the surface of the substrate, even comparatively low magnetic fields can be precisely detected.

The invention will be apparent from the following more detailed description taken in connection with the accompanying drawings.

Figure 1 and Figures 7A and 7B are diagrams each showing the construction of an embodiment of a magnetic field measuring apparatus according to this invention.

Figure 2 is an enlarged view of a magnetic material, which is included in the embodiment shown in Figure 1.

Figures 3, 4, 6 and 9 are graphs each showing the measured results of the relationship between the intensity of a magnetic field and the output in order to explain the operation of this invention.

Figure 5 is a graph showing the relationship between the thickness of a magnetic garnet film and the constant of proportion of square characteristics of an output and an applied magnetic field, and

Figure 8A to 8C are diagrams each showing the construction of a magnetic field detecting portion.

0046298

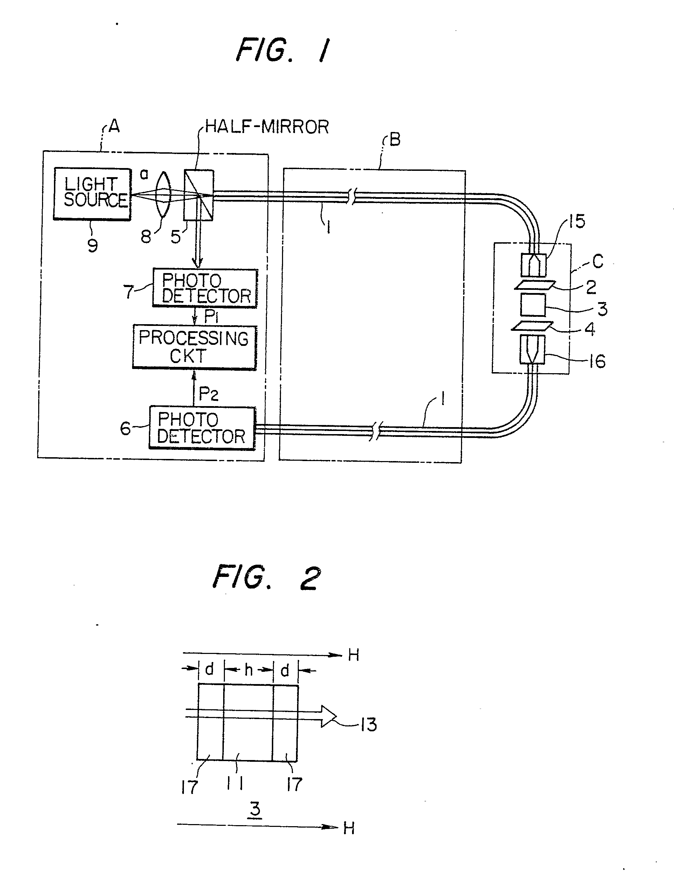

Figure 1 is a block diagram which shows the construction of an embodiment of an apparatus for measuring a magnetic field according to this invention. Referring to the figure, the magnetic-field measuring apparatus consists of a measuring portion A, a transmitting portion B and a detecting portion C. In the present embodiment, the detecting portion C exploits transmitted light having undergone the Faraday rotation. The measuring portion A has the same construction as in conventional optical measurement systems, and a light beam $\underline{a}$ emergent from a light source 9 is adjusted by a lens 8 so that the largest amount of light can enter an optical fiber 1. Through a semitransparent mirror 5, a part of the light beam from the lens 8 is coupled to the optical fiber 1 and is guided to the detecting portion C. The other part is guided to a photodetector 7 and becomes an output electric signal $P_1$. On the other hand, light from the detecting portion C is guided to a photodetector 6 by the optical fiber 1 and becomes an output electric signal $P_2$ as will be described later.

The signals $P_1$ and $P_2$ are applied to a processing circuit.

Between the end faces of the optical fiber 1, the detecting portion C is constructed of a focusing lens 15, a polarizer 2, a magnetic material 3 to be described in detail later, an analyzer 4 defining an angle of 45 $^{\circ}$ with respect to the polarizer 2, and a focusing lens 16. In this structure, when the light passes through the polarizer 2, only the linear polarization in only the vibrational direction of the polarizer is selectively transmitted to enter the magnetic material 3. When no magnetic field exists in the detecting portion C, the light which passes through the magnetic material 3 enters the analyzer 4 in the same polarized state. The vibrational direction of the analyzer is determined as follows.

Let it be supposed that the polarizer 2 and the analyzer 4 confront each other at an angle of $\theta$ radians. It is also supposed that the angle of the Faraday rotation upon application of a magnetic field is F radians. Then, the output $P_{OUT}$ which passes through the analyzer 4 becomes as follows with k being a constant of proportion:

$$P_{OUT} = k \cos^2(\theta - F) \tag{1}$$

The variation for the minute rotational angle F becomes:

$$\frac{dP_{OUT}}{dF} = k \sin\{2(\theta - F)\} \tag{2}$$

$$\fallingdotseq k \sin(2\theta)$$

It is understood that the output change is the maximum

at $\theta = \pi/4$. From Equation (1), the output at $\theta = \pi/4$ becomes:

$$P_{OUT} = \frac{k}{2} \{1 + \sin(2F)\} \qquad (3)$$

In a region of small angles F, this can be approximated as follows:

$$P_{OUT} = \frac{k}{2} \{1 + 2F\} \qquad (4)$$

It is understood that the linearity between the quantities F and $P_{OUT}$ is held. From this fact, it is desirable that the polarizer 2 and the analyzer 4 cross at $\pi/4$ or 45 °.

As shown in Figure 2, the magnetic material 3 has magnetic garnet films 17 of thicknesses $\underline{d}$ on both the end faces of a GGG (gadolinium gallium garnet) substrate 11 of a thickness $\underline{h}$. The substrate 11 has the end faces in the direction $\langle 111 \rangle$ of the crystal. The magnetic garnet films 17 are formed on the end faces of the substrate 11 by the liquid phase epitaxy (LPE process) or the chemical vapor deposition (CVD process). The magnetization direction of the film is in the traveling direction 13 of the light, that is, in the direction perpendicular to the end faces. As examples of the composition of the magnetic garnet film 17, the following are taken:

$$
\begin{aligned}
&(YSmLuCa)_3 (FeGe)_5 O_{12} &&\cdots e\\
&(YSm)_3 (FeGa)_5 O_{12} &&\cdots f\\
&Y_3 Fe_5 O_{12} &&\cdots g\\
&(BiSm)_3 (FeGa)_5 O_{12} &&\cdots l
\end{aligned}
\qquad (5)
$$

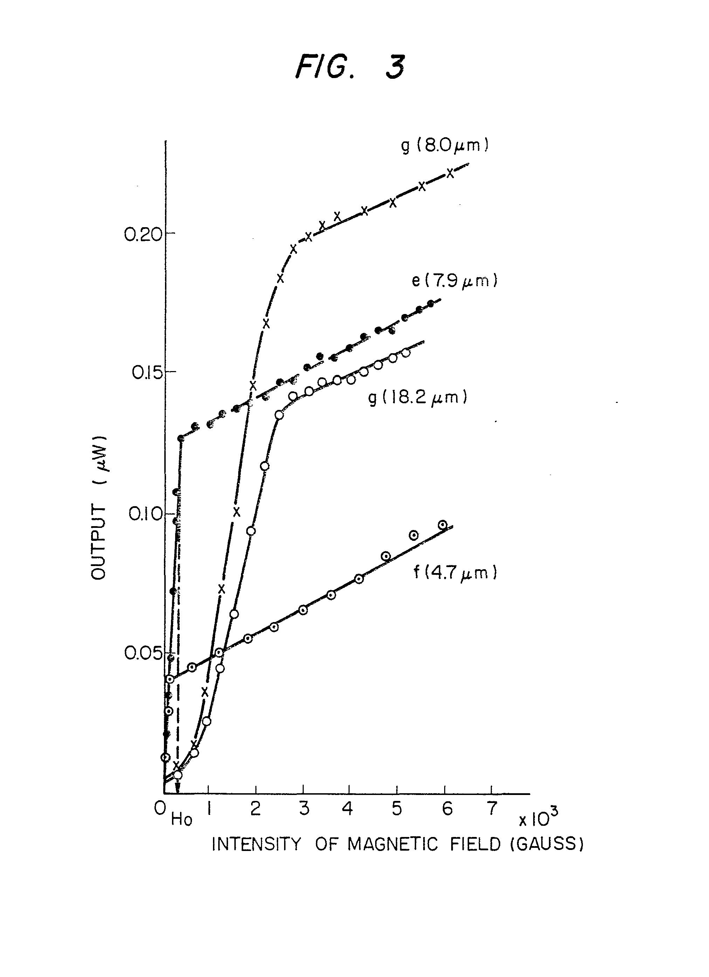

The characteristics of the magnetic material 3
will be described in detail by taking the several
films as examples. The substrate 11 used in measurements
was the GGG substrate in the direction $\langle 11 \rangle$ whose
thickness $h$ was 0.35 mm. For the sake of simplicity,
the polarizer 2 and the analyzer 4 were arranged in
the orthogonal relationship (i. e., at $\theta = \pi/2$ in equation (1)
not at 45 $^\circ$. There was investigated how the output $P_2$
varied when a magnetic field was applied perpendicularly
to the plane of the magnetic material 3, namely, in
the traveling direction of the light as indicated
by letter H in Figure 2. Figure 3 shows measurement
values at a light wavelength of 0.63 $\mu$m in the cases
where the compositions $e$, $f$ and $g$ were employed for
the films 17. Numerals enclosed in parentheses in
the figure denote the thicknesses $d$ of the films in
microns. All the outputs obtained increase abruptly
at low intensities of the magnetic field, and increase
at substantially equal gradients from certain intensities
(denoted by $H_0$ gausses) of the magnetic field. The
intensity $H_0$ differs depending upon the material used,
and in, for example, the magnetic garnet $e$, it is
approximately 300 gausses. The change of the output
occurs at the intensity $H_0$ on the basis of 1) the
fact that the Faraday rotation magnitude of the GGG substrate per unit magnetic field is small as compared with the same of the magnetic film and 2) the fact that the collapse field of the stripe domain of the film is $H_o$, which is small as compared with the saturation field $H_1$ of the substrate GGG. The fact that the high output is obtained at the low magnetic field as shown in Figure 3 is based on the Faraday rotation effect of the film, and the output beyond $H_o$ is based on the rotation effect of the GGG substrate. In view of these facts, when the magnetic material 3 having the magnetic garnet films on the GGG substrate is employed in the detecting portion, there is the great merit that a low magnetic field can be measured at a high sensitivity especially by the magnetic garnet films, while even a high magnetic field can be measured owing to the rotation effect of the substrate.

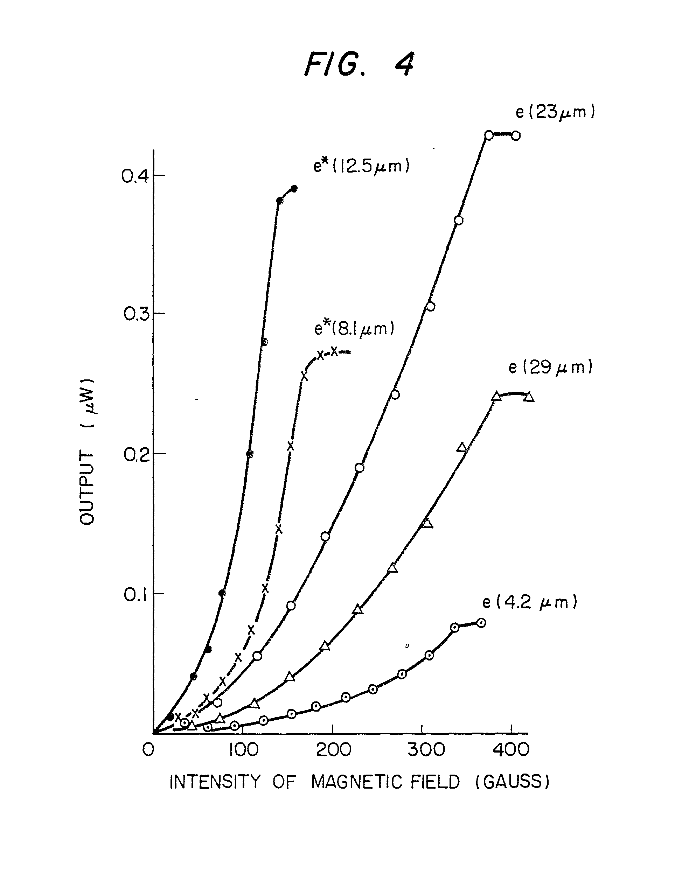

Especially for the preventive maintenance of high-voltage equipment, it is necessary to detect a magnetic field on the order of, particularly, 10 - 100 gausses. The characteristics were therefore studied more in detail below the collapse field $H_o$ of the stripe domain shown in Figure 3. The result is shown in Figure 4. The film used was of $\underline{e}$ in Equation (5). In the magnetic garnet $\underline{e}$, the collapse field $H_o$ of the stripe domain and the size of the stripe domain can be respectively varied by somewhat changing the amounts of substitution of iron Fe and germanium Ge in the composition indicated in Equation (5) and by changing the anisotropy energy in dependence on the amount of samarium Sm. Regarding the magnetic garnet $\underline{e}$, one in which the size of the stripe domain is 2 $\mu$m shall be denoted by mere $\underline{e}$, and one in which it is 7 $\mu$m shall be symbolized by $e^{*}$. In the figure, numerals in parentheses indicate the thicknesses (d) of the films as in the foregoing. From the results obtained, it is understood that the output varies substantially along a square curve versus the intensity of the magnetic field. This is based on the fact that when $\theta = \pi/2$ is put into Equation (1), the output is approximately indicated by square characteristics as follows:

$$P_{OUT} \fallingdotseq k \; F^{2} \tag{6}$$

As apparent from Figure 4, even with the identical composition, the detection outputs differ depending upon the thicknesses of the films. This is based on the mutually opposite phenomena owing to the increase of the thickness of the film that the transmission factor of light worsens due to absorption and that the Faraday rotation effect is enhanced. The product between the transmission factor and the Faraday rotation magnitude is usually called the figure of merit (FM).

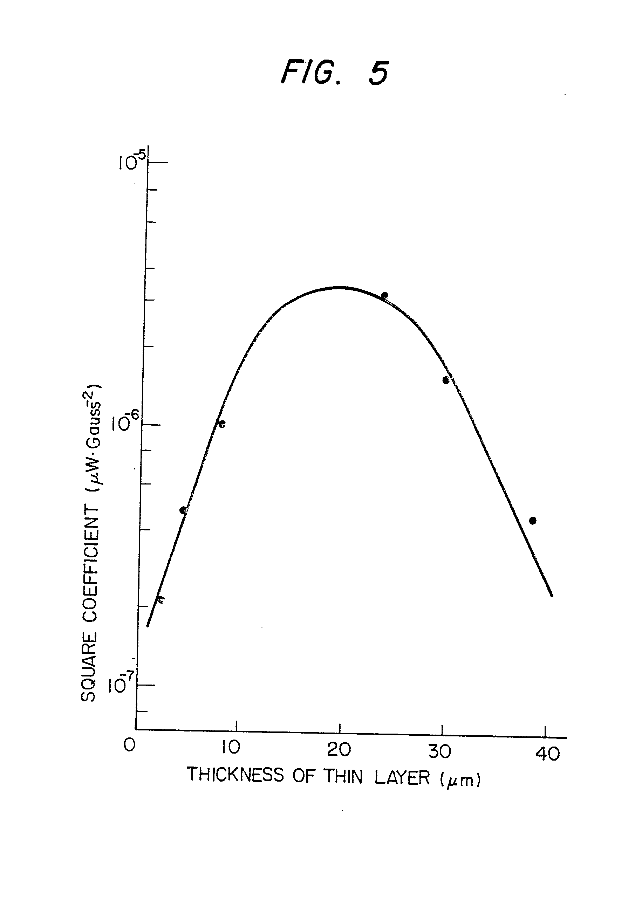

The FM will be evaluated by taking the magnetic garnet e as an example. When the proportional constant of the square characteristics is evaluated as a function of the thickness d, a result shown in Figure 5 is obtained. From this, it is understood that the optimum value $d_m$ exists in the thickness of the film of the magnetic garnet.

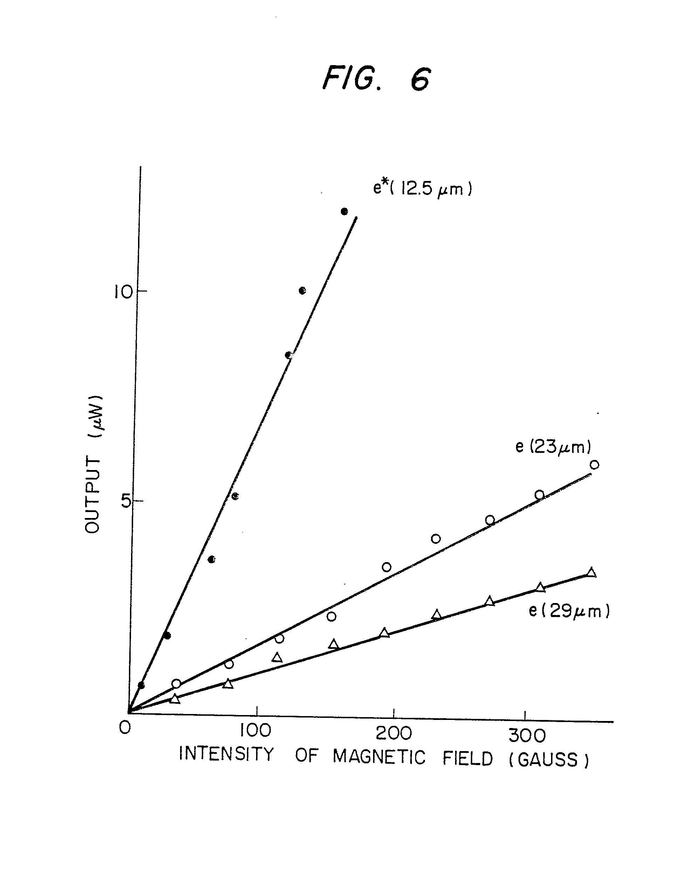

In the above, there has been described the case where the polarizer and the analyzer intersect orthogonally ($\theta = \pi/2$). Referring back to Figure 1, the case of $\theta = \pi/4$ will now be described. In Figure 6, the output variations dependent upon the magnetic field have been obtained by employing the same samples as those used in Figure 4. In comparison with the results of Figure 3, it is seen 1) that the output variation is as very great as approximately 30 times and 2) that the output varies rectilinearly with the intensity of the magnetic field. From these facts, it can be said that the $\pi/4$ crossing is the most suitable for the polarizer and the analyzer.

The Faraday rotation angle, F radian can be expressed by the product among a constant $V_e$ inherent in the material, the intensity H of the magnetic field and the thickness 2 $d_m$ ($d_m$ when the film is provided on one face). That is:

$$F = 2 V_e d_m H \qquad (7)$$

Referring back to Figure 1, the light beam guided by the optical fiber is radiated in parallel by the lens 15, only its linear polarization component is detected by the polarizer 2, and it is rotated $2 V_e d_m H$ (radian) by the applied magnetic field H. When the light passes through the analyzer 4, the intensity decreases to $\frac{1}{2} + 2 V_e d_m H$ times. The light is condensed by the lens 16, passes through the optical fiber 1 again, and is picked up by the detector 6. The output becomes approximately $P_2 = K P_1 (\frac{1}{2} + 2 V_e d_m H)$ in consideration of efficiency lowerings (K percent) due to the transmission loss of the optical fiber, the coupling losses in the detecting portion C, the transmission loss of the magnetic material 3, etc. The constant K is a quantity which is determined at the fabrication of the apparatus, and is known. From this expression, the magnetic field H can be conversely evaluated as follows:

$$H = \left\{ \frac{P_2}{K P_1} - \frac{1}{2} \right\} / 2 V_e d_m \qquad (8)$$

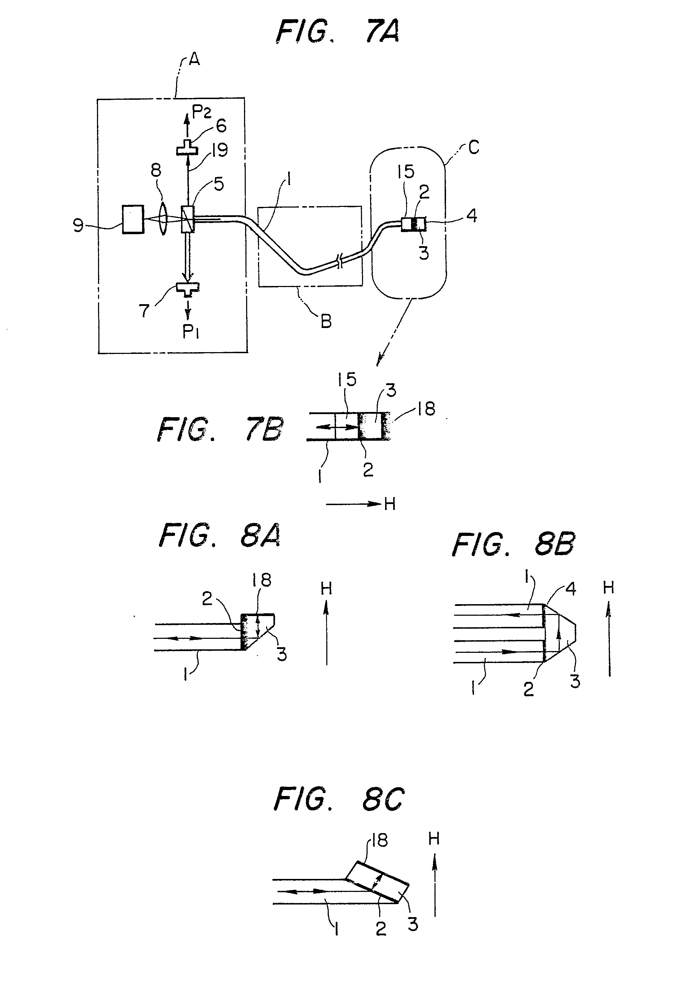

Figure 7A is a block diagram showing the construction of another embodiment of the magnetic-field measuring apparatus according to this invention, while Figure 7B is a partial enlarged view of the embodiment.

The detecting portion of the present embodiment uses reflected light instead of the transmitted light by coating the end face of the magnetic material 3 with a reflective film 18 which reflects the light of a wavelength employed most efficiently. In this structure, when the light passes through the polarizer 2, only the linear polarization in only the vibrational direction of the polarizer is selectively transmitted, whereupon it enters the magnetic material 3. In the absence of any magnetic field in the detecting portion C, the light having passed through the magnetic material 3 is reflected by the reflective film 18 and enters the polarizer 2 again in the same polarized state. Since the polarization direction of the reflected light is the same as that of the polarizer, the light is transmitted through the polarizer, whereupon it is guided to the measuring portion A again by the optical fiber 1 and is made emergent light 19 by the semitransparent mirror 5. This output is detected by the photodetector 6 into the electric signal $P_2$. Upon application of the magnetic field H, the output $P_2$ varies in conformity with the case of $\theta = 0$ in Equation (1). In this case, it is desirable that the thickness of the magnetic garnet film is made a half of the length $d_m$ at which the figure of merit FM of the transmission system becomes the maximum.

- 13 -

0046298

Figures 8A, 8B and 8C are views each showing the structure of another embodiment of the detecting portion. Since the Faraday rotation takes place when the traveling direction of light and the direction of a magnetic field have coincided, these embodiments are effective in case where the axial direction of the optical fiber and the direction of the magnetic field cross orthogonally. The structures in Figures 8A and 8C are applicable to the embodiment shown in Figures 7A and 7B. In each of these structures, the light polarized by the polarizer 2 is reflected into the direction of the magnetic field by a $45^{O}$-cut place of the magnetic material 3 and is returned to the original path by the reflective film 18. In the structure of Figure 8C, the end part of the optical fiber 1 is cut aslant and the magnetic material 3 is held in close contact therewith, whereby the magnetic field is measured by exploiting the oblique component thereof. The structure in Figure 8B is applied to the embodiment of Figure 1. The light polarized by the polarizer 2 is totally reflected by first and second inclined surfaces of the magnetic material 3 and is fed to the measuring portion via the analyer 4.

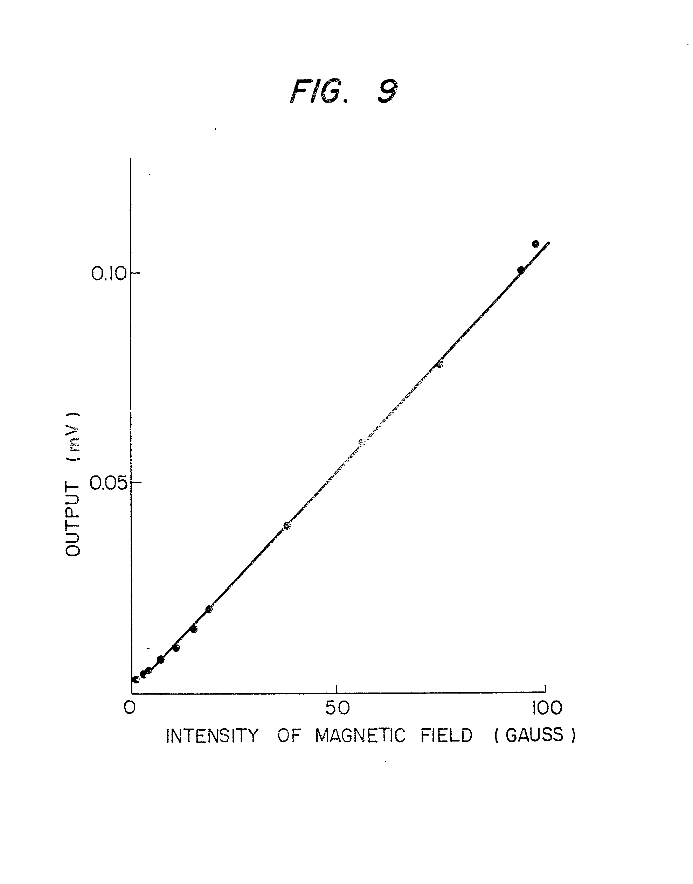

In the above embodiments, the magnetic field has been observed in one direction or with D.C. The magnetic field measuring apparatus of this invention, however, operates even when an A.C. magnetic field is applied. Such an example will be described. The construction of the detector portion was the same as shown in Figure 1, and the film used was e $^{*}$ (12.5 μm) indicated in Figure 4. Under the application of an A.C. magnetic field, the optical output was displayed on an oscilloscope, and the voltage of the vertical crest value was read. The result is shown in Figure 9. From this figure, it is understood that the output and the magnetic field are in a rectilinear relationship and that a magnetic field as low as 10 gausses can be detected.

- 14 -

0046298

## Patent claims

1. Apparatus for measuring a magnetic field, c h a r a c - t e r i z e d   i n   t h a t  there are provided a light source (9), a magnetic field detecting portion (C) including a medium (3) having the Faraday rotation, a measuring portion (A) measuring light from the detecting portion (C), and an optical fiber (1) connecting the light source (9), the detecting portion (C) and the measuring portion (A).

2. Apparatus according to claim 1, c h a r a c t e r i z e d  i n   t h a t  within the detecting portion (C), there is provided a magnetic garnet film, which is installed at an intermediate part or end part of the optical fiber (1) and which is placed in such a way in the magnetic field to be measured, that it is magnetized in the direction of the transmitting light.

3. Apparatus according to claim 2, c h a r a c t e r i z e d  i n   t h a t  the magnetic garnet film (7) is a medium represented by the formula:

$$R_3(Fe_{5-x}M_x)_5O_{12}$$

where R and M denotes at least one element selected from the following groups R = {Y, Ce, Pr, Nd, Bi, Pb, La, Sm, Eu, Gd, Er, Tm, Yb, Lu, Ca}      and M = {Ga, Ge, Al, Si, Sc, In, Cr}.

0046298

4. Apparatus according to claim 2 or 3, c h a r a c t e - r i z e d   i n   t h a t   the magnetic garnet film (17) is formed on at least one end face of a paramagnetic substrate (11) of gadolinium gallium garnet $Gd_3Ga_5O_{12}$, neody- mium gallium garnet $Nd_3Ga_5O_{12}$ or samarium gallium garnet $Sm_3Ga_5O_2$, whereby the direction of magnetization is perpendicular to the end face.

5. Apparatus according to one of the claims 2 to 4, c h a r a c t e r i z e d   i n   t h a t   the thickness of the magnetic garnet film (17) in the light transmitting direction is chosen in such a way so as to maximize the figure of the merit.

6. Apparatus according to one of the previous claims, c h a r a c t e r i z e d   i n   t h a t   the magnetic field detecting portion (C) is arranged between an optical fiber (1) leading to the light source (9) and an optical fiber (1) leading to the measuring portion (A) and that within the detecting portion (C) there are arranged a lens (15), a polarizer (2), a first magnetic garnet film (17), a paramagnetic substrate (11), a second magnetic garnet film (17), an analyzer (4) and a lens (16) in succession.

7. Apparatus according to claim 6, c h a r a c t e r i z e d   i n   t h a t   the polarizer (2) and the analyzer (4) define an angle of 45$^O$.

0046298

8.  Apparatus according to one of the claims 1 to 5,
c h a r a c t e r i z e d   i n   t h a t   the magnetic
field detecting portion (C) is arranged at the end of said
optical fiber (1) and there is formed a lens (15), a polarizer (2), a magnetic garnet film (17), a paramagnetic
substrate (11) and a reflective film (18) in succession.

## FIG. 1

A

HALF-MIRROR

B

LIGHT SOURCE

9

a

8

5

15

C

2

3

4

16

7

PHOTO DETECTOR

$P_1$

PROCESSING CKT

$P_2$

6

PHOTO DETECTOR

1

1

## FIG. 2

H

d

h

d

13

17

11

17

3

H

# FIG. 3

FIG. 4

FIG. 5

0046298

4/7

# FIG. 6

FIG. 7A

FIG. 7B

FIG. 8A

FIG. 8B

FIG. 8C

6/7

0046298

FIG. 9

# EUROPEAN SEARCH REPORT

**European Patent Office**

## DOCUMENTS CONSIDERED TO BE RELEVANT

| Category | Citation of document with indication, where appropriate, of relevant passages | Relevant to claim |
|---|---|---|
| X | US – A – 4 112 367 (G. HEPNER et al.)<br>* column 1, lines 24 to 41; column 2, lines 8 to 64; fig. 1 to 3 *<br>-- | 1-3,<br>5,6 |
| X | US – A – 3 621 390 (F.K. v. WILLISEN)<br>* column 2, line 67 to column 3, line 12; fig. 1, 2 *<br>-- | 1 |
| | DE – A – 2 419 443 (N.V. PHILIPS' GLOEI-LAMPENFABRIEKEN)<br>* claim 1 *<br>-- | 3 |
| | US – A – 3 573 099 (E.B. MOORE et al.)<br>* claim 1 *<br>-- | 3 |
| | US – A – 3 156 651 (S. GELLER)<br>* claims 1, 2 *<br>-- | 3 |
| | GB – A – 1 477 688 (SIEMENS AG)<br>* claims 1, 3 *<br>-- | 4 |
| | DE – A – 2 034 850 (SIEMENS AG)<br>* page 5, lines 18 to 22 *<br>---- | 7 |

**CLASSIFICATION OF THE APPLICATION (Int. Cl. 3)**

G 01 R 33/032
G 01 R 15/07
G 02 F 1/09
H 01 F 1/34
C 04 B 35/40

**TECHNICAL FIELDS SEARCHED (Int. Cl. 3)**

C 04 B 35/40
C 04 B 35/50
G 01 R 15/07
G 01 R 33/032
G 02 B 1/09
G 02 F 1/09
H 01 F 1/00
H 01 F 1/10
H 01 F 1/34

**CATEGORY OF CITED DOCUMENTS**

X: particularly relevant
A: technological background
O: non-written disclosure
P: intermediate document
T: theory or principle underlying the invention
E: conflicting application
D: document cited in the application
L: citation for other reasons

&: member of the same patent family, corresponding document

| | The present search report has been drawn up for all claims | |
|---|---|---|
| Place of search<br>Berlin | Date of completion of the search<br>11-11-1981 | Examiner<br>LEMMERICH |

EPO Form 1503.1 06.78